# EUROPEAN PATENT SPECIFICATION

(11) **EP 1 900 040 B1**
(45) Date of publication and mention of the grant of the patent: **03.05.2017**
(21) Application number: 05820596.4
(22) Date of filing: 09.11.2005
(51) Int. Cl.: H01L 33/50, H01L 33/54, H01L 33/62

(54) **LIGHT EMITTING DIODE AND METHOD OF FABRICATING THE SAME**
LEUCHTDIODE UND VERFAHREN ZU IHRER HERSTELLUNG
DIODE ÉMETTRICE DE LUMIÈRE ET SON PROCÉDÉ DE FABRICATION

(30) Priority: 04.07.2005 KR 20050059736
(43) Date of publication of application: 19.03.2008
(73) Proprietor: SEOUL SEMICONDUCTOR CO., LTD, Geumcheon-gu Seoul 153-023 (KR)
(72) Inventor: KIM, Do, Hyung 425-1604 Yeonggot Maeul Apt., Jangan-gu, Suwon 440-720 (KR); LEE, Chung-Hoon 305-701 Olympic Apt., Songpa-gu, Seoul 138-050 (KR)
(74) Representative: Stolmár & Partner Patentanwälte PartG mbB
(86) International application number: PCT/KR2005/003784
(87) International publication number: WO 2007/004775

(56) References cited:
- EP-A2- 1 198 016
- EP-A2- 1 408 559
- JP-A- 2000 022 217
- JP-A- 2001 135 861
- JP-A- 2001 308 393
- JP-A- 2003 303 999
- JP-A- 2004 253 745
- JP-A- 2005 019 997
- JP-A- 2005 091 675
- US-A- 5 832 600
- US-A1- 2004 263 073
- US-A1- 2005 056 858

## Description

### Technical Field

The present invention relates to a light emitting diode and a method of fabricating the same, and more particularly, to a light emitting diode with a frame, or submount, structure for allowing uniform application of a fluorescent substance thereon and a method of fabricating the light emitting diode.

### Background Art

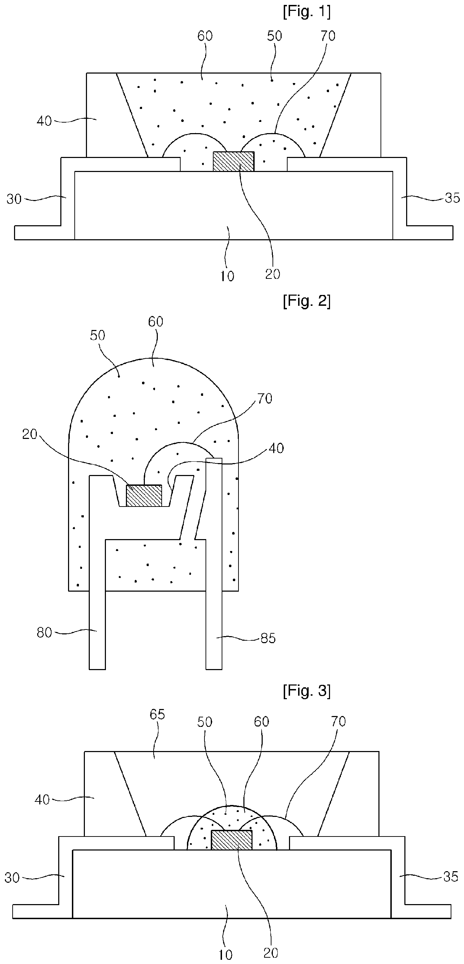

Figs.1 and 2 are schematic sectional views of light emitting diodes in which a fluorescent substance is applied in accordance with a prior art. Fig. 1 is a sectional view of a conventional top-type light emitting diode and Fig. 2 is a sectional view of a conventional lamp-type light emitting diode.

Referring to Fir.1, the light emitting diode comprises a substrate 10 with first and second lead terminals 30 and 35 formed thereon, a light emitting diode chip 20 mounted on the substrate 10, and a reflecting portion 40 formed on the substrate to surround the light emitting diode chip 20. The light emitting diode chip 20 is electrically connected to the first and second lead terminals 30 and 35 through wires 70. A molding portion 60 is formed on the light emitting diode chip 20 by filling a liquid epoxy resin or the like into the reflecting portion 40 and thermally curing the resin for a predetermined time so as to protect the light emitting diode chip 20. Further, a fluorescent substance 50 for absorbing light emitted from the light emitting diode chip 20 and performing wavelength conversion of the light into respective different wavelengths is mixed in the molding portion 60.

Referring to Fig. 2, the light emitting diode comprises a first lead terminal 80 with a reflecting portion 40 at an upper end thereof and a second lead terminal 85 spaced apart by a predetermined distance from the first lead terminal 80. Further, a light emitting diode chip 20 is mounted inside the reflecting portion 40 of the first lead terminal 80, and a molding portion 60 is formed on the light emitting diode chip 20 by applying a liquid epoxy resin or the like and thermally curing the resin for a predetermined time so as to protect the light emitting diode chip 20. Further, a fluorescent substance 50 for absorbing light emitted from the light emitting diode chip 20 and performing wavelength conversion of the light into respective different wavelengths is mixed in the molding portion 60.

When the fluorescent substance is applied as described above, the fluorescent substance with a higher specific gravity precipitates due to a difference in specific gravity between the fluorescent substance and the epoxy resin with a relatively lower specific gravity during the predetermined time when the liquid epoxy resin is cured. A difference in concentration within the liquid epoxy resin occurs due to such precipitation of the fluorescent substance, and thus, there is a problem with color reproducibility because light emitted from the light emitting diode chip is not uniform. Further, since a color speckle is produced, a great amount of fluorescent substance should be contained in the molding portion to express a uniform color, resulting in degradation of light emitting efficiency. Furthermore, since the fluorescent substance is not uniformly distributed, there is a problem in that the color of light emitted from the light emitting diode varies depending on an angle at which the light emitting diode is viewed.

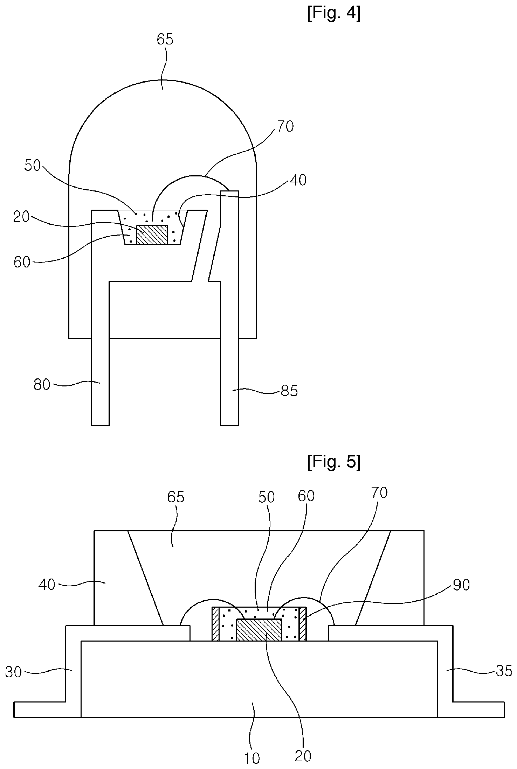

Figs. 3 and 4 are schematic sectional views of light emitting diodes in which a fluorescent substance is applied in accordance with another prior art. The light emitting diodes shown in Figs. 3 and 4 are different from those shown in Figs. 1 and 2 in that a mixture of a fluorescent substance and a resin is dotted with a predetermined thickness to encapsulate a light emitting diode chip and a molding portion is then formed thereon. However, remaining components of the light emitting diodes shown in Figs. 3 and 4 are identical to those of the light emitting diodes shown in Figs. 1 and 2.

Referring to Fig 3, in the light emitting diode, the mixture of fluorescent substance and resin is dotted on the light emitting diode chip 20, and the molding portion 65 is formed inside a reflecting portion 40. Referring to Fig. 4, the fluorescent substance 50 is injected only inside the reflecting portion 40, and a transparent epoxy resin is used for the peripheral molding portion 65 to enhance the transmissivity of light emitted from the light emitting diode chip 20.

In the case where the mixture of fluorescent substance and resin is applied as described above, the mixture may flow laterally. Thus, there is a problem in that the distance between the light emitting diode and the fluorescent substance varies and thus a color may not be uniformly expressed and two or more different colors may be produced depending on a light emitting region. Further, in case of Fig. 4, the luminous efficiency of light considerably decreases due to interference between the light emitting diode chip and the reflecting portion.

Fig. 5 is a schematic sectional view of a light emitting diode in which a fluorescent substance is applied in accordance with a further prior art. The light emitting diode of Fig. 5 further comprises a guide member 90 for preventing a mixture of fluorescent substance and resin from flowing outside a substrate or lead terminals when the mixture of fluorescent substance and resin is dotted on a light emitting diode chip. However, since an additional process should be added to attach the guide member 90, a fabricating process becomes complicated, resulting in increased production costs. Further, there is a problem in that luminous efficiency decreases and a great amount of fluorescent substance is consumed due to the guide member.
US 2005/056858 A1 discloses a light emitting device, wherein inner walls of a reflecting cup of the light emitting device include a base plane, a first pair of parallel planes, and a second pair of planes. The first pair of parallel planes is perpendicular to the base plane. The second pair of parallel planes is perpendicular to the base plane, and cross the first pair of parallel planes at right angles. An LED chip which emits a blue light is provided on the base plane. The LED chip is sealed in the cup by a fluorescent member including a fluorescent material, for example YAG. A ratio of a length of the first pair of parallel planes along a plane perpendicular to the optical axis of the light emitted from the LED chip and a length of the second pair of parallel planes along the perpendicular plane equals the aspect ratio of a photographing area of a camera which is used with the light emitting device.
US 2004/263073 A1 discloses light emitting devices having a phosphor layer that are useful as sources of white light, and other applications. The light emitting device has a LED and a phosphor composition positioned to receive light from the LED. The LED is adapted to emit cyan light, and the phosphor composition is adapted to absorb cyan light from the LED and emit red light.
EP 1 408 559 A2 discloses a blue light emitting element being mounted on a bottom of a case body. A cover member covers the blue light emitting element. Fluorescent material is mixed in the cover member for converting wavelength of light emitted from the blue light emitting element to adjust chromaticity of the light, and luminance reducing material for adjusting the luminance of the light is mixed in the cover member. A white light emitting device comprises: (i) a blue light emitting element; (ii) a cover for covering the blue light emitting element; (iii) fluorescent material for converting wavelength of light emitted from the blue light emitting element to adjust chromaticity of the light being mixed in the cover; and (iv) luminance reducing material for adjusting the luminance of the light being mixed in the cover.
JP 2001 308393 A discloses a light-emitting diode of a long-wavelength conversion type, utilizing a semiconductor light-emitting element for emitting visible light and phosphor emitting visible light whose wavelength is longer than that, and where the emission brightness is significantly improved on a long wavelength range with less phosphor to be used. A light-emitting diode is provided with a light-emitting element which emits visible light and a transmissive member which absorbs visible light from the light-emitting element and comprises a phosphor emitting visible light whose wavelength is longer that. Here, the transmissive member comprises a pigment through which the wavelength emitted from the phosphor transmits while the light from the light-emitting element is reflected on it.
JP 2004 253745 A discloses redundant blue LED elements being generated by restricting the wavelength of the blue LED element that is used to obtain the luminescence of desired intermediate colors in a pastel LED using one blue LED element to cause luminescence in intermediate colors by chromaticity correction. In a method of producing a pastel LED having a blue LED element and a coating resin member that coats the blue LED element and contains a phosphor and a coloring agent, the blue LED element is classified into a plurality of ranks according to its luminescence wavelength, and the phosphor and the coloring agent are included in the coating resin member by respectively different compounding conditions correspondingly to the rank of the wavelength.
JP 2003 303999 A is directed to the problem of life time of an LED element deteriorating, due to stresses applied to the LED element in accordance with the thermal expansion of configuring members, and discloses two symmetrical metal cores being fixed through electrically insulating adhesive so that the cross-sectional shape can be turned to be an inverted trapezoidal recessed part to form an almost stereoscopic metal core substrate, while a sub-mount substrate, where a predetermined electrode pan formed on an insulating substrate is mounted with an LED element with a solder bump, and a sub-mount sealed with sealing resin is formed so that the LED element can be coated, and the sub-mount is soldered by solder across the adhesive on a bottom face of the recessed part of the metal core substrate. A reflecting film, constituted by gloss silver plating, is formed on the recessed oblique face of the metal core substrate. A glass ceramic substrate or a glass epoxy substrate, whose thermal expansion coefficients are set between the LED element and the metal core substrate, is used for the sub-mount substrate. Thus, stresses generated due to temperature are relaxed, and a high reliability surface-mounted LED can be realized.
JP 2001135861 A discloses a semiconductor light-emitting device, wherein the blue light emitted from a blue-color light-emitting chip, for example, and yellow-green color which is wavelength-converted are evened to provide a pure white luminosity. A flip-chip type light-emitting element is conductively mounted on a sub-mount element, and the light-emitting element is sealed with a package of a resin comprising fluorescent material for wavelength conversion. The thickness of the package from the outside surface of the light-emitting element is almost constant in the entire orientation in light-emission direction so that the wavelength conversion by the fluorescent material is even in the entire orientation in light-emission direction of the light-emitting element.
JP 2000 022217 A is directed to restricting moisture reaching an element, and enhancing wet-resistance and reliability of an optical transmission system, and discloses a method, wherein an optical semiconductor element and a part of an element mounting member are coated with a sealing resin, and a plurality of undercut parts are provided as an interface path extension part around the optical semiconductor element of the element mounting member. An optical semiconductor element is disposed on a stem as an optical semiconductor element mounting member, so as to be electrically connected to each other. In the stem, a plurality of recessed grooves (undercut parts) is provided so as to enclose the optical semiconductor element. A resin is formed so as to coat the recessed groove and the optical semiconductor element, which is resin-sealed; such the recessed groove is formed, whereby a path length of an interface between the stem and the resin is considerably extended. For an arrival of moisture invaded from a resin end part to the interface at the optical semiconductor element, it must be diffused at a long distance of at least the recessed groove, thereby attaining large restraint effects for moisture.

US 5,832,600 A discloses a method for manufacturing a leadless-package type electronic part, the cost and the size of which can be reduced and which exhibits excellent reliability. The electronic part of a leadless package type includes a rectangular substrate having a plurality of external electrodes in the periphery thereof, an element part placed on the surface of the substrate while being electrically connected to the external electrodes, and molding resin for molding the element part onto the surface of the substrate, wherein the surface of the molding resin is formed to be flat, and each side surface of the molding resin is flush, or aligned, with a respective side surface of the substrate.

### Disclosure of Invention

### Technical Problem

The present invention is conceived to solve the aforementioned problems in the prior arts. Accordingly, an object of the present invention is to provide a light emitting diode and a method of fabricating the same, wherein the distance between a fluorescent substance and a light emitting diode chip is uniformly maintained when the fluorescent substance is applied to the light emitting diode, thereby reducing a color variation, i.e., generation of two or more different colors, and enhancing luminous efficiency.

### Technical Solution

According to aspects of the present invention for achieving the object, there are provided a light emitting diode, and a method of fabricating a light emitting diode according to the independent claims.
The light emitting diode comprises at least one light emitting diode chip; lead terminals for use in applying electric power to the light emitting diode chip; and a submount having the light emitting diode chip mounted thereon, the submount being formed to have a predetermined height and a shape geometrically similar to a shape of the light emitting diode chip in plan view.

The light emitting diode further comprises a molding portion having a fluorescent substance for converting the wavelength of light emitted from the light emitting diode chip, the molding portion being formed on the submount and the molding portion being formed to have a shape being identical to the shape of the submount in plan view.

The light emitting diode may further comprise a peripheral molding portion for encapsulating the light emitting diode chip.

The molding portion may be formed to have a shape corresponding to that of the light emitting diode chip.

The submount may be formed on one of the lead terminals.

The submount and the lead terminals may be formed integrally with each other.

The light emitting diode may further comprise a substrate and the submount may be formed on the substrate.

The submount and the substrate may be formed integrally with each other.

The light emitting diode may further comprise a housing for surrounding the substrate.

A barrier with a predetermined height may be formed along the periphery of a top surface of the submount.

The barrier and the submount may be formed integrally with each other.

The submount may be formed to have a rectangular shape.

A groove with a predetermined depth may be formed along the periphery of a top surface of the submount.

The method of fabricating a light emitting diode comprises the steps of forming a submount with a shape geometrically similar to a shape of a light emitting diode chip in plan view; mounting the light emitting diode chip on the submount; applying a predetermined amount of fluorescent substance as a molding portion on the submount, the molding portion being formed to have a shape being identical to the shape of the submount in plan view; and heating and curing the fluorescent substance.

A barrier with a predetermined height may be formed along the periphery of a top surface of the submount.

A groove with a predetermined depth may be formed along the periphery of a top surface of the submount.

### Brief Description of the Drawings

Figs.1 and 2 are schematic sectional views of light emitting diodes in which a fluorescent substance is applied in accordance with a prior art;
Figs. 3 and 4 are schematic sectional views of light emitting diodes in which a fluorescent substance is applied in accordance with another prior art;
Fig. 5 is a schematic sectional view of a light emitting diode in which a fluorescent substance is applied in accordance with a further prior art;
Figs. 6 and 7 are a perspective view and a sectional view of a light emitting diode according to a first embodiment of the present invention, respectively;
Fig. 8 is a sectional view of a light emitting diode according to a second embodiment of the present invention
Fig. 9 is a sectional view of a light emitting diode according to a third embodiment of the present invention;
Figs. 10 and 11 are sectional views of light emitting diodes according to fourth and fifth embodiments of the present invention, respectively;
Figs. 12 to 17 are views showing examples of a submount structure according to the present invention; and
Fig. 18 is a flowchart illustrating a method of fabricating a light emitting diode according to the present invention.

### Best Mode for Carrying Out the Invention

Hereinafter, preferred embodiments of the present invention will be described in detail with reference to the accompanying drawings.

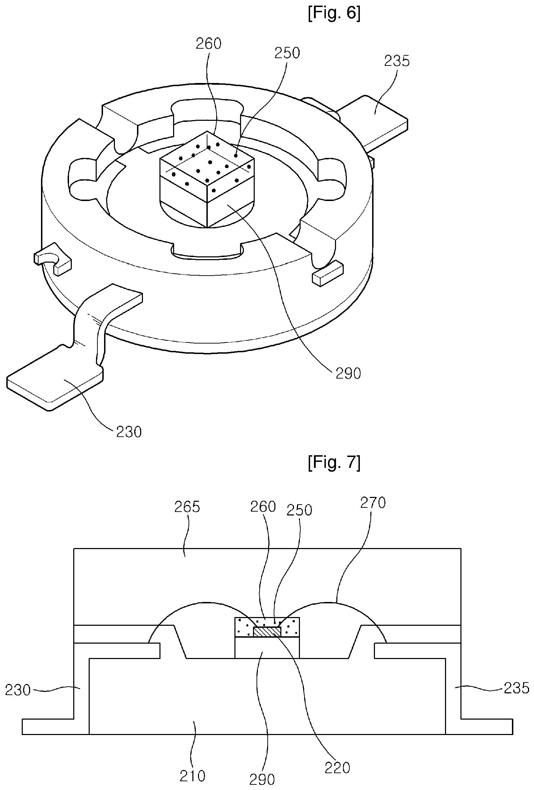

Figs. 6 and 7 are a perspective view and a sectional view of a light emitting diode according to a first embodiment of the present invention, respectively. That is, the figures are a perspective view and a sectional view of a chip-type light emitting diode according to the present invention, respectively.

Referring to Figs. 6 and 7, the light emitting diode comprises a substrate 210 with lead terminals 230 and 235 formed thereon, a submount 290 formed on the substrate 210, a light emitting diode chip 220 mounted on the submount 290, and wires 270 for connecting the light emitting diode chip 220 to the lead terminals 230 and 235. Further, a fluorescent substance 250 for converting the wavelength of light generated from the light emitting diode chip 220 is mixed with an encapsulant and then applied to the submount 290 to form a molding portion 260. Although the light emitting diode of this embodiment includes one light emitting diode chip 220, it is only for illustrative purposes and the light emitting diode may include a plurality of light emitting diode chips.

Further, a peripheral molding portion 265 is formed of a liquid epoxy resin or the like on the light emitting diode chip 220 to protect the light emitting diode chip 220. The peripheral molding portion 265 may be formed through an injection molding process using a predetermined resin, or through preparation thereof using an additional mold and subsequent pressurization or heat-treatment thereof. In this case, the peripheral molding portion 265 is formed using an epoxy resin, a silicone resin or the like. The peripheral molding portion 265 may be formed in various forms such as an optical lens or a flat plate.

Meanwhile, the submount 290 may be formed separately from the substrate 210 and then bonded thereto. Otherwise, the submount 290 and the substrate 210 may be formed integrally with each other. In this case, the substrate 210 may be formed using a metal slug or a thermally conductive resin.

Further, the encapsulant is made of a liquid epoxy resin or silicone resin.

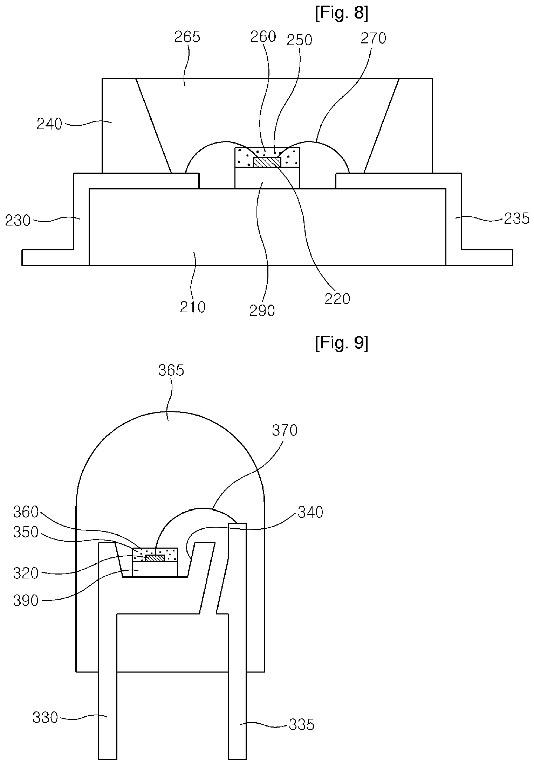

Fig. 8 is a sectional view of a light emitting diode according to a second embodiment of the present invention, namely. That is, the figure is a schematic sectional view of a top-type light emitting diode according to the present invention.

Referring to Fig. 8, the light emitting diode of the second embodiment is similar to that of the first embodiment except that a reflecting portion is formed on a substrate. Thus, only parts different from each other will be described below.

The light emitting diode comprises a substrate 210, lead terminals 230 and 235 formed on the substrate, a submount 290, a reflecting portion 240, a light emitting diode chip 220 mounted on the submount 290, and wires 270 for connecting the light emitting diode chip 220 to the lead terminals 230 and 235. Further, a fluorescent substance 250 for converting the wavelength of light generated from the light emitting diode chip 220 is mixed with an encapsulant and then applied to the submount 290 to form a molding portion 260. A peripheral molding portion 265 is formed on the light emitting diode chip 220 to protect the light emitting diode chip 220. In this case, the peripheral molding portion 265 is made of a predetermined resin, preferably, an epoxy resin or silicone resin.

Meanwhile, the reflecting portion 240 is formed to surround at least one light emitting diode chip 220 on the substrate 210. At this time, to enhance the luminance and condensing efficiency of light, the reflecting portion 240 may be formed in such a manner that an inner wall of the reflecting portion 240 surrounding the light emitting diode chip 220 has a predetermined slope.

Fig. 9 is a sectional view of a light emitting diode according to a third embodiment of the present invention. That is, this figure is a schematic sectional view of a lamp- type light emitting diode according to the present invention.

Referring to Fig. 9, the light emitting diode comprises a first lead terminal 330 with a reflecting portion 340 at a top end thereof, and a second lead terminal 335 spaced apart by a predetermined distance from the first lead terminal 330. Further, a submount 390 is formed inside the reflecting portion 340 of the first lead terminal 330, and a light emitting diode chip 320 is mounted on the submount 390.

Furthermore, a fluorescent substance 350 for converting the wavelength of light generated from the light emitting diode chip 320 is mixed with an encapsulant and then applied to the submount 390 to form a molding portion 360. A peripheral molding portion 365 is formed on the light emitting diode chip 320 by applying a predetermined resin thereto and thermally curing the resin for a predetermined time so as to protect the light emitting diode chip 320. In this case, the peripheral molding portion 365 may comprise an epoxy resin or silicone resin.

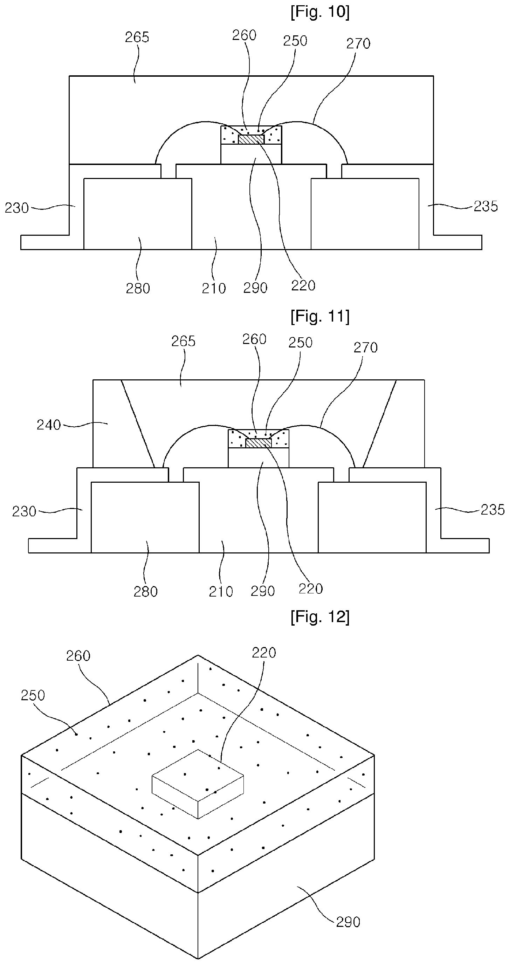

Figs. 10 and 11 are sectional views of light emitting diodes according to fourth and fifth embodiments of the present invention. That is, the figures are schematic sectional views of light emitting diodes each of which has a housing.

The light emitting diode according to the fourth embodiment of the present invention shown in Fig. 10 is different from that of the first embodiment in that it further comprises a housing 280 for surrounding a substrate. However, remaining components thereof are identical to each other.

The light emitting diode according to the fifth embodiment of the present invention shown in Fig. 11 is different from that of the second embodiment in that it further comprises a housing 280 for surrounding a substrate. However, remaining components thereof are identical to each other.

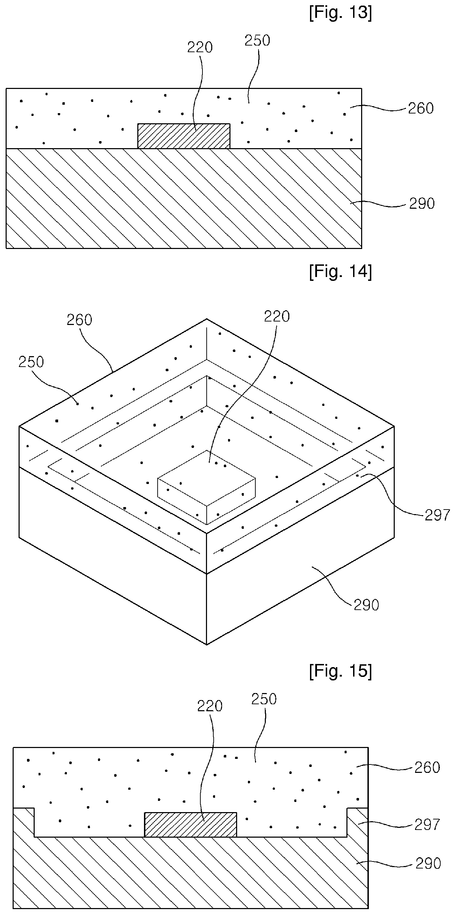

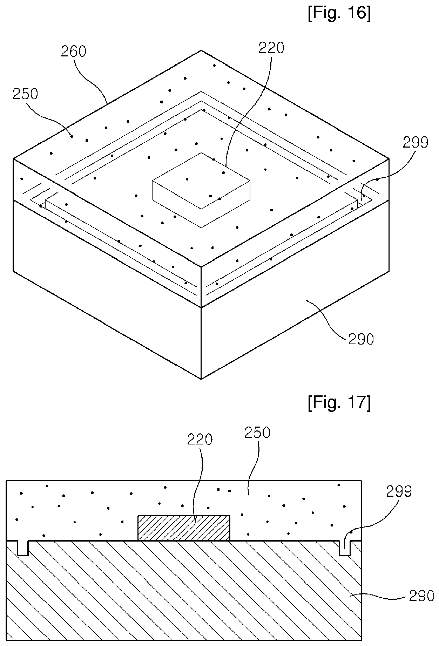

Figs. 12 and 13 are a perspective view and a sectional view showing an example of a submount structure according to the present invention, respectively. Figs. 14 and 15 are a perspective view and a sectional view showing another example of the submount structure according to the present invention. Figs. 16 and 17 are a perspective view and a sectional view showing a further example of the submount structure according to the present invention.

Referring to Figs. 12 and 13, the submount 290 is constructed in the same shape as the light emitting diode chip 220, i.e., in the form of a rectangle, to be sized about 1.5 or 2 times as large as that of the light emitting diode chip 220. Although the light emitting diode chip and the submount in this embodiment are constructed in the form of rectangles, they are not limited thereto but may be constructed in various forms. In this case, the submount and the light emitting diode chip are constructed to be in the same shape.

After a light emitting diode chip 220 is mounted on a central portion of a top surface of the submount 290 with the above mentioned shape and size, and a mixture of fluorescent substance and encapsulant is then dotted thereon, a molding portion 260 is constructed in the same shape as the submount 290. Thus, a uniform distance is established between the light emitting diode chip 220 and the molding portion 260. In other words, the molding portion 260 is constructed in the same shape of the light emitting diode chip 220.

Referring to Figs. 14 and 15, a submount structure of this embodiment is similar to that shown in Figs. 12 and 13 but is different therefrom only in that a barrier 297 with a predetermined height is formed along the periphery of the top surface of the submount 290.

The barrier 297 functions to lead the formation of the molding portion 260 using the mixture of fluorescent substance 250 and encapsulant such that the molding portion has the same shape as the light emitting diode chip 220. At this time, the barrier 297 may be formed integrally with the submount 290.

Referring to Figs. 16 and 17, a submount structure of this embodiment is similar to that shown in Figs. 12 and 13 but is different therefrom only in that a groove 299 with a predetermined depth is formed along the periphery of the top surface of the submount 290.

Similarly to the barrier, the groove 299 functions to lead the formation of the molding portion 260 using the mixture of fluorescent substance 250 and encapsulant such that the molding portion has the same shape as the light emitting diode chip.

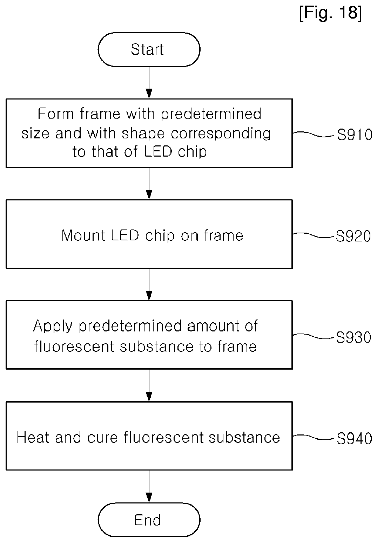

Fig. 18 is a flowchart illustrating a method of fabricating a light emitting diode according to the present invention.

Referring to Fig. 18, a process of forming a submount with a predetermined size and the same shape as a light emitting diode chip is first performed (S910).

A light emitting diode chip is mounted on the submount formed in step S910 (S920).

Thereafter, a predetermined amount of fluorescent substance is applied to the submount (S930). At this time, the fluorescent substance is mixed with an encapsulant, e.g., a liquid epoxy resin or silicone resin, and then applied to the submount.

Meanwhile, although the submount is formed in the same shape as the light emitting diode chip as described above, the submount is formed to be larger than the light emitting diode chip. Further, a barrier with a predetermined height may be formed along the periphery of a top surface of the submount. Otherwise, a groove with a predetermined depth may be formed along the periphery of the top surface of the submount.

Thereafter, a process of heating and curing the fluorescent substance applied to the submount is then performed (S940).

The foregoing is merely the exemplary embodiments of the light emitting diode and the method of fabricating the same. The present invention is not limited to the embodiments. It will be readily understood by those skilled in the art that various modifications and changes can be made thereto without departing from the technical spirit and scope of the present invention defined by the appended claims. It is also apparent that the modifications and changes fall within the scope of the present invention.

### Industrial Applicability

According to the present invention described above, a light emitting diode chip is mounted on a submount with a shape corresponding to that of the light emitting diode chip and a fluorescent substance is then dotted thereon, so that a uniform distance is established between the light emitting diode chip and molding portion, thereby reducing a color variation, i.e., generation of two or more different colors, and enhancing luminous efficiency.

## Claims

1. A light emitting diode, comprising:
- at least one light emitting diode chip (220);
- lead terminals (230, 235) for use in applying electric power to the light emitting diode chip (220);
- a submount (290) having the light emitting diode chip (220) mounted thereon, the submount (290) being formed to have a predetermined height and a shape geometrically similar to a shape of the light emitting diode chip (220) in plan view; and
- a molding portion (260) having a fluorescent substance for converting the wavelength of light emitted from the light emitting diode chip (220), the molding portion (260) being formed on the submount wherein
- the molding portion (260) is formed to have a shape being identical to the shape of the submount (290) in plan view.

2. The light emitting diode as claimed in claim 1, further comprising:
- a peripheral molding portion (265) for encapsulating the light emitting diode chip (220).

3. The light emitting diode as claimed in claim 1, wherein:
- the submount (290) is formed on one of the lead terminals (230, 235).

4. The light emitting diode as claimed in claim 3, wherein:
- the submount (290) and the lead terminal (230, 235) are formed integrally with each other.

5. The light emitting diode as claimed in claim 1, further comprising:
- a substrate (210), the submount (290) being formed on the substrate (210).

6. The light emitting diode as claimed in claim 5, wherein:
- the submount (290) and the substrate (210) are formed integrally with each other.

7. The light emitting diode as claimed in claim 5, further comprising:
- a housing for surrounding the substrate (210).

8. The light emitting diode as claimed in claim 1, wherein:
- a barrier (297) with a predetermined height is formed along the periphery of a top surface of the submount (290).

9. The light emitting diode as claimed in claim 8, wherein:
- the barrier (297) and the submount (290) are formed integrally with each other.

10. The light emitting diode as claimed in claim 1, wherein:
- a groove (299) with a predetermined depth is formed along the periphery of a top surface of the submount (290).

11. The light emitting diode as claimed in claim 1, wherein:
- the submount (290) is formed to have a rectangular shape.

12. A method of fabricating a light emitting diode, comprising:
(a) forming a submount (290) with a shape geometrically similar to a shape of a light emitting diode chip (220) in plan view;
(b) mounting the light emitting diode chip (220) on the submount (290);
(c) applying a predetermined amount of fluorescent substance as a molding portion (260) on the submount (290), the molding portion (260) being formed to have a shape being identical to the shape of the submount (290) in plan view; and
(d) heating and curing the fluorescent substance.

13. The method as claimed in claim 12, wherein:
- a barrier (297) with a predetermined height is formed along the periphery of a top surface of the submount (290).

14. The method as claimed in claim 12, wherein:
- a groove (299) with a predetermined depth is formed along the periphery of a top surface of the submount (290).

## Patentansprüche

1. Leuchtdiode umfassend:
- mindestens einen Leuchtdiodenchip (220);
- Leiterklemmen (230, 235) zur Verwendung bei der Anwendung von elektrischem Strom auf den Leuchtdiodenchip (220);
- eine Unterbefestigung (290), auf der ein Leuchtdiodenchip (220) befestigt ist, wobei die Unterbefestigung ausgebildet ist, um eine vorbestimmte Höhe und eine Form, die geometrisch einer Form des Leuchtdiodenchips (220) in der Draufsicht ähnelt; und
- einen Formteil (260) mit einer fluoreszierenden Substanz zur Umwandlung der Wellenlänge des vom Leuchtdiodenchips (220) emittierten Lichts, wobei der Formteil (260) auf der Unterbefestigung ausgebildet ist,
wobei
der Formteil (260) ausgeformt ist, um eine Form zu haben, die identisch mit der Form der Unterbefestigung (290) in Draufsicht ist.

2. Leuchtdiode gemäß Anspruch 1, weiter umfassend:
- einen umgebenden Formteil (265) zum Einkapseln des Leuchtdiodenchips (220).

3. Leuchtdiode gemäß Anspruch 1, wobei:
- die Unterbefestigung auf einer der Leiterklemmen (230, 235) ausgebildet ist.

4. Leuchtdiode gemäß Anspruch 3, wobei
- die Unterbefestigung (290) und die Leiterklemme (230, 235) aus einem Stück ausgebildet sind.

5. Leuchtdiode gemäß Anspruch 1, weiter umfassend:
- ein Substrat (210), wobei die Unterbefestigung (290) auf dem Substrat (210) ausgebildet ist.

6. Leuchtdiode gemäß Anspruch 5, wobei:
- die Unterbefestigung (290) und das Substrat (210) aus einem Stück ausgebildet sind.

7. Leuchtdiode gemäß Anspruch 5, weiter umfassend:
- ein Gehäuse zum Umgeben des Substrats (210).

8. Leuchtdiode gemäß Anspruch 1, wobei:
- eine Sperre (297) mit einer vorbestimmten Höhe entlang des Umfangs einer oberen Oberfläche der Unterbefestigung (290) ausgebildet ist.

9. Leuchtdiode gemäß Anspruch 8, wobei:
- die Sperre (297) und die Unterbefestigung (290) aus einem Stück ausgebildet sind.

10. Leuchtdiode gemäß Anspruch 1, wobei:
- ein Spalt (299) mit einer vorbestimmten Tiefe entlang des Umfangs einer oberen Oberfläche der Unterbefestigung (290) ausgebildet ist.

11. Leuchtdiode gemäß Anspruch 1, wobei
- die Unterbefestigung (290) ausgebildet ist, um ein rechteckige Form zu haben.

12. Verfahren zum Herstellen einer Leuchtdiode, umfassend:
a) Ausbilden einer Unterbefestigung (290) mit einer Form, die geometrisch einer Form eines Leuchtdiodenchips (220) in Draufsicht ähnelt;
b) Befestigen des Leuchtdiodenchips (220) auf der Unterbefestigung (290);
c) Anwenden einer vorbestimmten Menge an fluoreszierendem Substrat als Formteil (260) auf die Unterbefestigung (290), wobei der Formteil (260) ausgebildet ist, um eine Form, die identisch mit der Form der Unterbefestigung (290) in Draufsicht ist, zu haben; und
d) Erhitzen und Aushärten des fluoreszierenden Substrats.

13. Verfahren gemäß Anspruch 12, wobei:
- eine Sperre (297) mit einer vorbestimmten Höhe entlang des Umfangs einer oberen Oberfläche der Unterbefestigung (290) ausgebildet ist.

14. Verfahren gemäß Anspruch 12, wobei:
- ein Spalt (299) mit einer vorbestimmten Tiefe entlang des Umfangs einer oberen Oberfläche der Unterbefestigung (290) ausgebildet ist.

## Revendications

1. Diode électroluminescente comprenant:
- au moins une puce de la diode électroluminescente (220);
- bornes de raccordement (230, 235) à être utilisées dans l'application d'une énergie électrique sur la puce de la diode électroluminescente (220);
- un sous-support (290), sur lequel la puce de la diode électroluminescente (220) est monté, le sous-support étant formé pour avoir une hauteur prédéterminée et une forme géométriquement similaire à une forme de la puce de la diode électroluminescente vue en plan ; et
- une partie de moulage (260) ayant une substance fluorescente pour convertir la longueur d'onde de la lumière émise par la puce de la diode électroluminescente (220), la partie de moulage (260) étant formée sur le sous-support,
dans laquelle
la partie de moulage (260) est formée pour avoir une forme identique à la forme du sous-support (290) vue en plan.

2. Diode électroluminescente selon la revendication 1, comprenant en outre:
- une partie de moulage périphérique (265) pour encapsuler la puce de la diode électroluminescente (220).

3. Diode électroluminescente selon la revendication 1, dans laquelle
- le sous-support est formé sur l'une des bornes de raccordement (230, 235).

4. Diode électroluminescente selon la revendication 1, dans laquelle
- le sous-support (290) et les bornes de raccordement (230, 235) sont formés intégralement.

5. Diode électroluminescente selon la revendication 1, comprenant en outre:
- un substrat (210), le sous-support (290) étant formé sur le substrat (210).

6. Diode électroluminescente selon la revendication 5, dans laquelle:
- le sous-support (290) et le substrat (210) sont formés intégralement.

7. Diode électroluminescente selon la revendication 5, comprenant en outre:
- un boîtier pour entourer le substrat (210).

8. Diode électroluminescente selon la revendication 1, dans laquelle
- une barrière (297) avec une hauteur prédéterminée est formée autour de la périphérie d'une surface du haut du sous-support (290).

9. Diode électroluminescente selon la revendication 8, dans laquelle
- la barrière (297) et le sous-support (290) sont formés intégralement.

10. Diode électroluminescente selon la revendication 1, dans laquelle
- une rainure (299) avec une profondeur prédéterminée est formée autour de la périphérie d'une surface du haut du sous-support (290).

11. Diode électroluminescente selon la revendication 1, dans laquelle
- le sous-support (290) est formé pour avoir une forme rectangulaire.

12. Procédé pour la production d'une diode électroluminescente, comprenant:
a) former un sous-support (290) avec une forme qui est géométriquement similaire à une forme de la puce de la diode électroluminescente vue en plan ;
b) monter la puce de la diode électroluminescente (220) sur le sous-support (290);
c) appliquer une quantité prédéterminée d'un substrat fluorescent comme partie de moulage (260) sur le sous-support (290), la partie de moulage (260) étant formée pour avoir une forme identique à la forme du sous-support (290) vue en plan; et
d) chauffer et durcir le substrat fluorescent.

13. Procédé selon la revendication 12, dans lequel:
- une barrière (297) avec une hauteur prédéterminée est formée autour de la périphérie d'une surface du haut du sous-support (290).

14. Procédé selon la revendication 12, dans lequel:
- une rainure (299) avec une profondeur prédéterminée est formée autour de la périphérie d'une surface du haut du sous-support (290).
